# EUROPÄISCHE PATENTSCHRIFT

(11) **EP 1 563 554 B1**
(45) Veröffentlichungstag und Bekanntmachung des Hinweises auf die Patenterteilung: **04.01.2012**
(21) Anmeldenummer: 03785509.5
(22) Anmeldetag: 13.11.2003
(51) Int. Cl.: H01L 51/05, H01L 51/40

(54) **ORGANISCHES ELEKTRONISCHES BAUELEMENT MIT GLEICHEM ORGANISCHEM MATERIAL FÜR ZUMINDEST ZWEI FUNKTIONSSCHICHTEN**
ORGANIC ELECTRONIC COMPONENT COMPRISING THE SAME ORGANIC MATERIAL FOR AT LEAST TWO FUNCTIONAL LAYERS
COMPOSANT ELECTRONIQUE ORGANIQUE COMPORTANT LE MEME MATERIAU ORGANIQUE POUR AU MOINS DEUX COUCHES FONCTIONNELLES

(30) Priorität: 19.11.2002 DE 10253955
(43) Veröffentlichungstag der Anmeldung: 17.08.2005
(73) Patentinhaber: PolyIC GmbH & Co. KG, 90763 Fürth (DE)
(72) Erfinder: FIX, Walter, 90763 Fürth (DE); ROST, Henning, 91056 Erlangen (DE)
(74) Vertreter: Zinsinger, Norbert
(86) Internationale Anmeldenummer: PCT/DE2003/003776
(87) Internationale Veröffentlichungsnummer: WO 2004/047194

(56) Entgegenhaltungen:
- WO-A-03/067680
- US-A- 5 691 089
- DE LEEUW D M ET AL: "Polymeric integrated circuits and light-emitting diodes" ELECTRON DEVICES MEETING, 1997. TECHNICAL DIGEST., INTERNATIONAL WASHINGTON, DC, USA 7-10 DEC. 1997, NEW YORK, NY, USA,IEEE, US, 7. Dezember 1997 (1997-12-07), Seiten 331-336, XP010265518 ISBN: 0-7803-4100-7
- DAI L ET AL: "I2-DOPING OF 1,4-POLYDIENES" SYNTHETIC METALS, ELSEVIER SEQUOIA, LAUSANNE, CH, Bd. 69, Nr. 1-3, 24. Juli 1994 (1994-07-24), Seiten 563-566, XP001051921 ISSN: 0379-6779
- DAI L ET AL: "CONJUGATION OF POLYDIENES BY OXIDANTS OTHER THAN IODINE" SYNTHETIC METALS, ELSEVIER SEQUOIA, LAUSANNE, CH, Bd. 86, Nr. 1-3, 1997, Seiten 1893-1894, XP001051655 ISSN: 0379-6779
- XIUYING QIAO ET AL: "The FeCl/sub 3/-doped poly(3-alkyithiophenes) in solid state" SYNTH. MET., Bd. 122, Nr. 2, 1. Juni 2001 (2001-06-01), Seiten 449-454, XP001197314 ELSEVIER, SWITZERLAND ISSN: 0379-6779
- KAWASE T ET AL: "INKJET PRINTED VIA-HOLE INTERCONNECTIONS AND RESISTORS FOR ALL-POLYMER TRANSISTOR CIRCUITS" ADVANCED MATERIALS, VCH VERLAGSGESELLSCHAFT, WEINHEIM, DE, Bd. 13, Nr. 21, 2. November 2001 (2001-11-02), Seiten 1601-1605, XP001129628 ISSN: 0935-9648

## Beschreibung

Die vorliegende Erfindung beschreibt ein organisches elektronisches Bauelement wie einen organischen Feld-Effekt-Transistor (OFET), bei dem ein einziges organisches Material für zumindest zwei Funktionsschichten, beispielsweise als leitendes und als halbleitendes Funktionsmaterial, dient. Außerdem beschreibt die Erfindung ein effizientes Verfahren, um in einem Prozessschritt zwei Funktionsschichten, zum Beispiel Source- und Drain Elektroden sowie die Halbleiterschicht für den Einsatz in organischen Feld Effekt Transistoren, zu erzeugen.

Bekannt ist beispielsweise aus der PCT/DE 02/01948 ein organisches elektronisches Bauelement, bei dem die leitende Schicht aus dotierten konjugierten Systemen wie dotiertem Polyacetylen oder Polyanilin und die halbleitende Schicht aus konjugierten Systemen wie Polythiophen oder Polythienylenvinylen (PTV) im wesentlichen beschaffen ist. Bei den bekannten organischen elektronischen Bauelementen ist die halbleitende Funktionsschicht in der Regel immer aus einem anderen organischen Material wie die leitende Funktionsschicht, so dass immer zumindest für halbleitende und leitende Funktionsschicht zwei verschiedene Funktionsschichten aufeinanderliegen und in zwei Prozessschritten hergestellt werden.

Das Dokument Synthetic Materials, Bd. 69, (1995), Seiten 563-566 beschreibt ein Verfahren, um Bereiche eines nichtleitenden Polydiens halbleitend zu machen. Eine cis-Polydienschicht wird in ausgewählten Bereichen bestrahlt und somit in diesen Bereichen zur trans-Form umgewandelt. Die Schicht wird danach in Jod eingetaucht, wobei die trans-Bereiche dotiert und dadurch halbleitend werden, während die cis-Berieche nicht beeinflusst sind und isolierend bleiben.

Bei der Herstellung von organischen elektronischen Bauelementen wie beispielsweise OFETs in Top-Gate-Konfiguration wird bisher auf einem Trägersubstrat aus Glas oder Plastik eine leitfähige Funktionsschicht aus einem konjugierten Polymer (z.B. Polyanilin, PEDOT/PSS etc.) durch entweder Drucken, Rakeln, oder Spin-Coating aufgebracht. Bei den beiden letztgenannten Methoden schließt sich gegebenenfalls noch ein Strukturierungsprozess an, mit dem die Source- und Drain-Elektroden erzeugt werden, die beim Drucken direkt erzeugt werden können. Auf diese Funktionsschicht wird in einem weiteren Prozessschritt eine organische Halbleiterschicht aus einem anderen konjugierten Polymer aufgebracht, wobei sicherzustellen ist, dass weder das eingesetzte Lösungsmittel für das Halbleitermaterial noch das Halbleitermaterial selbst die untenliegenden Polymerelektroden angreift (d.h. an-, ab- oder auflöst). Weiterhin ist zu beachten, dass Elektroden und Halbleiter "gut zueinander passen" d.h. sowohl in Hinblick auf mechanische Haftung als auch im Hinblick auf gute Übereinstimmung von Workfunction und HOMO-Wert aufeinander abgestimmt sind. Dieses Verfahren ist aufwendig und kostspielig und daher besteht der Bedarf diese Methode zu verbessern, insbesondere Prozessschritte bei der Herstellung einzusparen.

Aufgabe der Erfindung ist es, ein Verfahren zur Herstellung eines organisches elektronisches Bauelement zu schaffen, bei dem ein einziges organisches Material zur Herstellung zumindest zweier Funktionsschichten, beispielsweise der leitenden und der halbleitenden, eingesetzt werden kann, wobei beide Funktionsschichten, also die untere strukturierte leitende Funktionsschicht und die anschließende halbleitende Funktionsschicht, zusammen in einem Prozessschritt, quasi als eine Funktionsschicht, aufgebracht werden.

Gegenstand der Erfindung ist ein Verfahren zur Herstellung eines organischen elektronischen Bauelements, bei dem in einem einzigen Prozessschritt innerhalb einer halbleitenden Funktionsschicht aus einem konjugierten Polymer leitende Bereiche erzeugt werden, in dem Teile der Funktionsschicht durch Dotieren mit einem Oxidationsmittel behandelt werden.

Nach einer Ausführungsform handelt es sich um ein Verfahren zur Herstellung eines organischen elektronischen Bauelements, bei dem in einem einzigen Prozessschritt Elektroden und/oder Leiterbahnen und halbleitende Funktionsschicht strukturiert in einem einzigen organischen Material erzeugt werden.

Nach einer Ausführungsform des Verfahrens wird in die halbleitende Funktionsschicht durch partielle Abdeckung und darauffolgende Behandlung der nicht abgedeckten Bereiche mit einem Oxidationsmittel gezielt eine leitfähige Struktur eingebracht.

Nach einer Ausführungsform wird mittels eines Photolacks die halbleitende Schicht partiell so abgedeckt, dass die nicht abgedeckten Bereicht zur Erzeugung von Elektroden und/oder Leiterbahnen durch in-Kontakt-Bringen mit einem Oxidationsmittel verwendet werden können.

Nach einer Ausführungsform wird das Oxidationsmittel durch Drucken partiell auf die halbleitende Funktionsschicht aufgebracht.

Nach der Erfindung wird mittels des Oxidationsmittels eine partielle Oxidation der halbleitenden Funktionsschicht durchgeführt.

Als organisches Material wird hier unter anderem ein Werkstoff bezeichnet, der durch gezielte Reduktion oder Oxidation ganz oder teilweise und/oder in bestimmten Bereichen in seinen elektrischen Eigenschaften wie der Leitfähigkeit veränderbar ist. Die gezielte Oxidation/Reduktion erfolgt chemisch und/oder elektrochemisch, also galvanisch und kann z.B. auch nach dem Aufbringen und Strukturieren eines Photolacks mit nachfolgender chemischer und/oder elektrochemischer/elektrischer Behandlung der freiliegenden Bereiche erfolgen.

Der Begriff "organisches Material" und/oder "Funktionspolymer" umfasst hier alle Arten von organischen, metallorganischen und/oder anorganischen Kunststoffen, die im Englischen z.B. mit "plastics" bezeichnet werden. Es handelt sich um alle Arten von Stoffen mit Ausnahme der Halbleiter, die die klassischen Dioden bilden (Germanium, Silizium), und der typischen metallischen Leiter. Eine Beschränkung im dogmatischen Sinn auf organisches Material als Kohlenstoff enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich.

Als Halbleitermaterial für den Einsatz in organischen elektronischen Bauelementen wie OFETs werden beispielsweise konjugierte Polymere wie Poly(phenylenvinylen) (PPV), spezielle Polyfluorene (PF) oder auch Polyalkylthiophene PAT beschrieben. Es ist bekannt, dass man derartige Spezialpolymere durch sogenanntes Dotieren, d.h. durch eine Redoxreaktion mit einem Redoxmittel wie die Oxidation mit Oxidationsmitteln wie (Jod (J₂), Brom (Br₂), Eisen (III) chlorid (FeCl₃), Nitrosyltetrafluoroborat (NOBF₄) und Kaliumperoxodisulfat (K₂S₂O₈), etc.) in den leitfähigen Zustand überführen kann. Erzeugt man nun auf einem geeigneten Trägermaterial (Glas, Plastik) durch Drucken, Rakeln, Spin-coating, Aufsprayen etc. eine homogene Schicht eines organischen Funktionsmaterials das als Halbleitermaterial verwendet werden soll, so ist es möglich, durch Nutzung eines abschirmenden Materials, z.B. eines Photolacks (d.h. Photolithographie) oder Aufdrucken eines Ätzresists, bestimmte Bereiche der halbleitenden Funktionsschicht so abzudecken, dass die unbedeckten Bereiche der halbleitenden Funktionsschicht durch in Kontakt bringen mit Oxidationsmitteln in die leitfähige Form überführt werden können. Eine andere Möglichkeit besteht darin, das Oxidationsmittel direkt auf den Halbleiter aufzudrucken.

So ist beispielsweise eine Elektrode und/oder eine Leiterbahn aus der oxidierten Form des halbleitenden Materials in einer nichtleitfähigen Matrix des gleichen halbleitenden Materials herstellbar.

Im Folgenden soll die Erfindung noch anhand eines Ausführungsbeispiels näher erläutert werden:
Auf einem PET-Substrat wird durch Spin-Coating eine homogene Schicht des halbleitenden Polymers Poly(3,3"-dihexyl-2,2'-5,2"-terthiophen)PDHTT aufgebracht. Darauf wird eine Funktionsschicht eines Positiv-Photoresists (z.B. AZ 1512 von Clariant) durch Spin-coating aufgeschleudert. Durch eine Schattenmaske wird der Photolack mit UV-Licht belichtet und anschließend entwickelt. Auf diese Weise entstehen definierte Bereiche, an denen PHDTT nicht mehr vom Photolack geschützt ist. Beim Eintauchen des Substrats in eine 0,1 molare Lösung von Eisen(III)chlorid-hydrat in Acetonitril werden die freiliegenden Bereiche zur leitenden Form oxidiert. Man spült noch mit Lösungsmittel das Oxidationsmittel weg, trocknet und entfernt den auf dem Substrat verbliebenen Photolack. Auf diese Weise erhält man leitfähige Strukturen in einer nichtleitfähigen Matrix.

Die leitenden oder halbleitenden Bereiche in der halbleitenden oder leitenden Matrix werden auch durch Dotieren, beispielsweise durch eine partiell geführte Redoxreaktion erhalten.

Für die elektrischen Eigenschaften eines organischen elektronischen Bauelements wie eines OFETs ergeben sich durch die Einheitlichkeit der leitenden und halbleitenden Funktionsschicht zwei wesentliche Vorteile:
Zum einen wird der Übergangswiderstand zwischen Elektrode und Halbleiter deutlich verringert (üblicherweise entstehen an Grenzflächen zwischen zwei verschiedenen organischen Funktionsmaterialien Übergangswiderstände durch Raumladungszonen infolge unterschiedlicher Fermi-Niveaus und/oder durch Potentialbarrieren infolge schwacher Bindungen der organische Funktionsmaterialien untereinander).

Des Weiteren wird der Serienwiderstand vermieden, der bei organischen elektronischen Bauelementen wie OFETs dadurch entsteht, dass die Halbleiterschicht sich zwischen Source/Drain-Elektrode und Isolator befindet, aber der Stromkanal nur an der Grenzfläche Halbleiter/Isolator entsteht. Der Stromkanal hat somit keinen direkten Kontakt zur Source/Drain-Elektrode. Bei organischen elektronischen Bauelementen wie OFETs, die nach der Erfindung mit einheitlichem organischen Funktionsmaterial für halbleitende und leitende Funktionsschicht gemacht sind, hat der Stromkanal direkten Kontakt zu den Source/Drain Elektroden.

Als Folge des beschriebenen Aufbaus eines elektronischen organischen Bauelements wie eines OFETs lassen sich schnellere Schaltungen realisieren, die außerdem niedrigere Versorgungsspannungen brauchen.

Schließlich bietet die Erfindung einen erheblichen Vorteil bei der Herstellung, weil nur durch einen einzigen Prozessschritt zwei Funktionsschichten eines elektronischen organischen Bauelements erzeugt werden können. So werden beispielsweise Elektroden/Leiterbahnen und Halbleiter strukturiert in einer Schicht erzeugt. Außerdem werden mechanische Haftungsprobleme vermieden, die durch Verwendung von verschiedenen Materialien für Source/Drain Elektroden und/oder Leiterbahnen und Halbleiter normalerweise zu überwinden sind.

## Patentansprüche

1. Verfahren zur Herstellung eines organischen elektronischen Bauelements, bei dem in einem einzigen Prozessschritt innerhalb einer halbleitenden Funktionsschicht aus einem konjugierten Polymer leitende Bereiche erzeugt werden, indem Teile der Funktionsschicht durch Dotieren mit einem Oxidationsmittel behandelt werden.

2. Verfahren nach Anspruch 1, bei dem das Dotieren als Bedrucken ausgeführt wird.

3. Verfahren nach einem der vorstehenden Ansprüche, bei dem das konjugierte Polymer Poly(phenylenvinylen), Polyfluoren und/oder ein Polyalkylthiophen ist.

4. Verfahren nach einem der vorstehenden Ansprüche, bei dem vor dem Dotieren mit dem Oxidationsmittel die halbleitende Funktionsschicht partiel abgedeckt wird, um nicht abgedeckte Bereiche, die mit dem Oxidationsmittel in Berührung kommen und abgedeckte Bereiche, die mit dem Oxidationsmittel nicht in Berührung kommen, zu erzeugen.

5. Verfahren nach einem der vorstehenden Ansprüche, bei dem mittels eines Photolacks die halbleitende Schicht partiell abgedeckt wird.

## Claims

1. Method for producing an organic electronic component, wherein, in a single process step, conductive regions are produced within a semiconducting functional layer composed of a conjugated polymer, by parts of the functional layer being treated by doping with an oxidizing agent.

2. Method according to Claim 1, wherein the doping is embodied as printing.

3. Method according to either of the preceding claims, wherein the conjugated polymer is poly(phenylene vinylene), polyfluorene and/or a polyalkylthiophene.

4. Method according to any of the preceding claims, wherein the semiconducting functional layer is partially covered prior to doping with the oxidizing agent, in order to produce uncovered regions, which come into contact with the oxidizing agent, and covered regions, which do not come into contact with the oxidizing agent.

5. Method according to any of the preceding claims, wherein the semiconducting layer is partially covered by means of a photoresist.

## Revendications

1. Procédé de production d'un composant électronique organique dans lequel, dans une étape de procédé unique, des zones conductrices sont générées dans une couche fonctionnelle semi-conductrice d'un polymère conjugué, en traitant des parties de la couche fonctionnelle par dopage avec un agent oxydant.

2. Procédé selon la revendication 1, dans lequel le dopage est réalisé sous la forme d'une impression.

3. Procédé selon l'une des revendications précédentes, dans lequel le polymère conjugué est le poly(phénylènevinylène), le polyfluorène et/ou un polyalkylthiophène.

4. Procédé selon l'une des revendications précédentes, dans lequel avant le dopage avec l'agent oxydant, la couche fonctionnelle semi-conductrice est recouverte partiellement pour générer des zones non recouvertes qui entrent en contact avec l'agent oxydant et des zones recouvertes qui n'entrent pas en contact avec l'agent oxydant.

5. Procédé selon l'une des revendications précédentes, dans lequel la couche semi-conductrice est recouverte partiellement au moyen d'un enduit photorésistant.
